Europäisches Patentamt

European Patent Office

Office européen des brevets

(11) Veröffentlichungsnummer: **0 226 247**
**A2**

(12) **EUROPÄISCHE PATENTANMELDUNG**

(21) Anmeldenummer: 86202140.9

(22) Anmeldetag: 02.12.86

(51) Int. Cl.⁴ **G01N 24/08**

(30) Priorität: **12.12.85 DE 3543854**

(43) Veröffentlichungstag der Anmeldung:
**24.06.87 Patentblatt 87/26**

(84) Benannte Vertragsstaaten:
**BE DE FR GB IT NL SE**

(71) Anmelder: **Philips Patentverwaltung GmbH**
**Billstrasse 80**
**D-2000 Hamburg 28(DE)**
**DE**
Anmelder: **N.V. Philips' Gloeilampenfabrieken**
**Groenewoudseweg 1**
**NL-5621 BA Eindhoven(NL)**
**BE FR GB IT NL SE**

(72) Erfinder: **Kunz, Dietmar, Dr.**
**Berliner Strasse 10**
**D-2085 Quickborn(DE)**

(74) Vertreter: **Hartmann, Heinrich, Dipl.-Ing.**
**Philips Patentverwaltung GmbH Billstrasse**
**80 Postfach 10 51 49**
**D-2000 Hamburg 28(DE)**

(54) **Kernspintomographieverfahren und Anordnung zur Durchführung des Verfahrens.**

(57) Die Erfindung betrifft ein Verfahren zur Erzeugung von getrennten Fett-und Wasserbildern bzw. einer Anordnung zur Durchführung dieses Verfahrens. Getrennte Fett-bzw. Wasserbilder werden mit Hilfe einer Sequenz von drei Hochfrequenzimpulsen erreicht, von denen der zweite und der dritte identische Flipwinkel aufweisen und voneinander einen zeitlichen Abstand haben, der der Hälfte des Kehrwertes der Differenz der Larmorfrequenzen von an Wasser einerseits und an Fett andererseits gebundenen Wasserstoffprotonen oder einem ungeradzahligen Vielfachen dieses Wertes entspricht.

FIG. 3

## "Kernspintomographieverfahren und Anordnung zur Durchführung des Verfahrens"

Die Erfindung betrifft ein Kernspintomographieverfahren, bei dem in ener Vielzahl von Sequenzen in Anwesenheit eines stationären homogenen Magnetfeldes ein dazu senkrecht verlaufendes Hochfrequenz-Magnetfeld sowie magnetische Gradientenfelder in einem Untersuchungsbereich wirksam sind, wobei in jeder Sequenz zunächst ein erster Hochfrequenzimpuls erzeugt wird und anschließend ein zweiter und ein dritter Hochfrequenzimpuls, die miteinander identisch sind, wobei das zeitliche Integral über die Gradientenfelder zwischen dem zweiten und dem dritten Hochfrequenzimpuls Null ist und wobei ein in einem Meßintervall nach dem dritten Hochfrequenzimpuls auftretendes Echosignal zur Erzeugung eines Bildes des Untersuchungsbereiches herangezogen wird, und eine Anordnung zur Durchführung dieses Verfahrens.

Ein solches Verfahren ist aus der EP-OS 0 143 602 bekannt. Die drei Hochfrequenzimpulse haben einen Flipwinkel von je 90°, d.h. die Kernmagnetisierung wird durch sie jeweils um 90° gekippt. Der zeitliche Abstand zwischen dem zweiten und dem dritten Hochfrequenzimpuls ist so gering, daß sie zusammen einen 180° Impuls bilden, so daß zusammen mit dem ersten Hochfrequenzimpuls eine für die sogenannten Spin-Echo-Verfahren geeignete Pulssequenz entsteht (wenn hierbei und im folgenden von dem zeitlichen Abstand, dem Zeitraum o.dgl. zwischen Signalen, Impulsen, Intervallen usw. die Rede ist, dann ist damit der zeitliche Abstand, Zeitraum o.dgl. zwischen den zeitlichen Mitten der Signale, Impulse Intervalle usw. gemeint).

Es ist bekannt, daß die Larmorfrequenz von in Fett gebundenen Wasserstoffprotonen geringfügig von der Larmorfrequenz von in Wasser gebundenen Wasserstoffprotonen abweicht (rund 3,3 ppm). Aufgrund dieser geringen Differenz werden bei einer Anregung durch einen Hochfrequenzimpuls bei den bekannten Verfahren die Wasserstoffprotonen sowohl im Fett als auch im Wasser angeregt. Infolgedessen enthält das anschließend aufgenommene Echosignal Anteile, die von der Fettverteilung im Untersuchungsbereich abhängen und Anteile, die von der Wasserverteilung im Untersuchungsbereich abhängen. Es ist in vielen Fällen erwünscht, Bilder zu erzeugen, die nur die Fettverteilung zeigen -im folgenden kurz "Fettbilder" genannt -, bzw. Bilder, die nur die Wasserverteilung zeigen -im folgenden kurz "Wasserbilder" genannt.

Es sind verschiedene Verfahren bekannt, um getrennte Fett-und Wasserbilder zu erzeugen.

Bei den sogenannten CHESS-Verfahren werden Hochfrequenzimpulse verwendet, die so -schmalbandig sind, daß entweder nur die in Fett oder nur die in Wasser enthaltenen Wasserstoffprotonen angeregt werden. Dies erfordert, daß die Dauer der Hochfrequenzimpulse groß ist im Vergleich zum Kehrwert der Differenz der genannten Frequenzen. Da die Larmorfrequenzen und damit auch die genannte Differenz der Feldstärke des stationären homogenen Magnetfeldes proportional ist, bedeutet dies, daß insbesondere bei niedrigen Feldstärken relativ lang dauernde Hochfrequenzimpulse erforderlich sind. Es dauert daher in diesen Fällen relativ lange vom Beginn eines solchen Hochfrequenzimpulses bis zum Erhalt des Echosignals. Der dadurch verstärkte Einfluß der Relaxation auf das Echosignal macht das Verfahren in den meisten Fällen ungeeignet.

Insbesondere bei Kernspintomographen mit niedrigen magnetischen Feldstärken ist man daher zu der Dixon'schen Methode und verwandten Verfahren übergegangen (Radiology, Vol. 153 (1984), Seiten 189-194). Diese Verfahren basieren darauf, daß man durch zeitliches Auseinanderlegen der Gradienten-und der sogenannten Hahn-Echos im Gradienten-Echo-Signal eine definierte Phase zwischen Fett-und Wasserbild erzeugt. So ist es dann möglich, neben dem normalen Fett-plus Wasser-Bild ein Fett-minus Wasser-Bild zu erzeugen und hieraus später reine Fett-und reine Wasserbilder zu berechnen. Der Nachteil eines solchen Verfahrens besteht darin, daß man -auch wenn man nur an einem Fett-oder Wasser-Bild interessiert ist - zunächst zwei Aufnahmen machen muß, und daß das nachträgliche Berechnen der reinen Bilder voraussetzt, daß man keine Phasenfehler zwischen den beiden ursprünglichen Bildern hat.

Es ist Aufgabe der vorliegenden Erfindung, ein Verfahren anzugeben, daß es ohne schmalbandige Hochfrequenzimpulse und ohne nachträgliche Überlagerung von Mischbildern gestattet, Fett-bzw. Wasserbilder zu erzeugen.

Diese Aufgabe wird ausgehend von einem Verfahren der eingangs genannten Art dadurch gelöst, daß zur getrennten Erzeugung von Fett-bzw. Wasserbildern der zeitliche Abstand zwischen dem zweiten und dem dritten Hochfrequenzimpuls die Hälfte des Kehrwertes der Differenz der Larmorfrequenz von in Wasser und in Fett gebundenen Wasserstoffprotonen ist oder ein ungeradzahliges Vielfaches davon.

Die Differenz der Larmorfrequenzen von in Wasser und in Fett gebundenen Wasserstoffprotonen beträgt rund 3,3 ppm der jeweiligen Larmorfrequenz. Wenn die magnetische Induktion des stationären homogenen Magnetfeldes beispielsweise 2 T beträgt, dann liegt die Larmorfrequenz der Wasserstoffprotonen bei rund 85 MHz und die Differenz der Larmorfrequenzen bei rund 28l Hz, so daß die Hälfte des Kehrwertes etwa bei l,8 ms liegt.

Die Erfindung basiert auf der Erkenntnis, daß das Kernspin-Resonanzsignal, das nach dem dritten Impuls auftritt, aus einem stimulierten Echosignal und einem Spin-Echosignal besteht. Das stimulierte Echosignal tritt im zeitlichen Abstand dtl nach dem dritten Hochfrequenzimpuls auf; dtl ist dabei der zeitliche Abstand zwischen dem ersten und dem zweiten Impuls. Das stimulierte Echosignal hat eine Amplitude, die dem Quadrat des Sinus des Flipwinkels proportional ist. Dieses Signal beinhaltet die Summe von Fett-und Wasserbild.

Das Spin-Echosignal enthält zwei Komponenten, von denen die eine im zeitlichen Abstand dtl-dt2 nach dem zweiten Hochfrequenzimpuls und die andere im zeitlichen Abstand dtl + dt2 (dt2 ist der zeitliche Abstand zwischen dem zweiten und dem dritten Impuls) nach dem dritten Hochfrequenzimpuls folgt. Die beiden Spin-Echosignalkomponenten haben eine Amplitude, die dem Flipwinkel des zweiten bzw. des dritten Hochfrequenzimpulses proportional ist und jeweils genau halb so groß ist, wie die Amplitude des stimulierten Echosignals - wenn der zweite und der dritte Hochfrequenzimpuls den gleichen Flipwinkel haben. Die beiden Spin-Echokomponenten enthalten das Differenzbild aus Fett und Wasser. Infolgedessen ist das im Abstand dtl von dem dritten Hochfrequenzimpuls auftretende zusammengesetzte Echosignal entweder nur von der Fettverteilung oder nur von der Wasserverteilung abhängig.

Zur Erzeugung eines Bildes müssen bekanntlich magnetische Gradientenfelder während bzw. nach der beschriebenen Impulssequenz angelegt werden. Dies kann bei der Erfindung in der üblichen Weise erfolgen. Wesentlich ist aber, daß das zeitliche Integral über die Gradientenfelder zwischen dem zweiten und dem dritten Impuls Null ist. Im übrigen können die Gradientenfelder in bekannter Weise geschaltet werden -z.B. so, wie in der EP-OS 0 l43 602 beschrieben. Das optimale Signal/Rauschverhältnis ergibt sich gemäß einer Weiterbildung der Erfindung erst dadurch, daß die zeitliche Lage des Meßintervalls und der zeitliche Verlauf der Gradientenfelder derart gewählt ist, daß das zeitliche Integral über die Gradientenfelder -mit Ausnahme etwaiger der Phasenkodierung dienender Gradientenfelder -zwischen dem ersten und dem zweiten Hochfrequenzimpuls gleich dem zeitlichen Integral über diese Gradientenfelder zwischen dem dritten Hochfrequenzimpuls und dem Meßintervall ist, und daß der zeitliche Abstand des Meßintervalls vom dritten Hochfrequenzimpuls gleich dem zeitlichen Abstand des zweiten Hochfrequenzimpulses vom ersten Hochfrequenzimpuls ist.

Wie erwähnt, müssen der zweite und der dritte Hochfrequenzimpuls den gleichen Flipwinkel hervorrufen. Insofern müssen sie also identisch sein. Sie können jedoch unterschiedliche Phasenlagen in bezug auf ein mit der Larmorfrequenz mitrotierendes Koordinatensystem aufweisen. -Weil die Amplitude des Kernspin-Resonanzsignals wie erwähnt dem Quadrat des Sinus des Flipwinkels proportional ist, ist nach einer Weiterbildung der Erfindung vorgesehen, daß der zweite und der dritte Impuls einen Flipwinkel von je 90° aufweisen. In diesem Fall ergibt sich nämlich ein größeres Kernspin-Resonanzsignal als bei allen anderen Flipwinkeln. Das gleiche gilt übrigens auch, wenn der erste Hochfrequenzimpuls ein 90° Impuls ist.

Bei der erfindungsgemäßen Sequenz der Hochfrequenzimpulse ergibt sich ein Kernresonanzsignal, das entweder nur von der Wasserverteilung oder nur von der Fettverteilung im Untersuchungsbereich abhängig ist. Entspricht beispielsweise der zeitliche Mittelwert der Frequenz für den zweiten und den dritten Hochfrequenzimpuls der Larmorfrequenz von Wasser, dann hängt das Kernspin-Resonanzsignal nur von der Wasserverteilung im Untersuchungsbereich ab, während es ausschließlich von der Fettverteilung abhängt, wenn der Mittelwert der Frequenz jedes Hochfrequenzimpulses der Larmorfrequenz der im Fett gebundenen Wasserstoffprotonen entspricht. Wollte man auf diese Weise zwei verschiedene, die Fett-bzw. Wasserverteilung zeigende Bilder erzeugen, müßten die Sequenzen wiederholt werden.

Es können jedoch beide Arten von Signalen empfangen werden, wenn nach einer Weiterbildung die Sequenz so ausgestaltet ist, daß in jeder Sequenz im Anschluß an den dritten Hochfrequenzimpuls noch ein l80°-Impuls erzeugt wird, und daß die zeitliche Lage des Meßintervalls und der zeitliche Verlauf der Gradientenfelder derart ist, daß das zeitliche Integral über die Gradientenfelder -mit Ausnahme etwaiger für die Phasenkodierung bestimmter Gradientenfelder -im Zeitraum nach dem Hochfrequenzimpuls den Wert des zeitlichen Integrals über dieses Feld zwischen dem ersten Hochfrequenzimpuls und dem l80°-Hochfrequenzimpuls während des Meßintervalls erreicht. Bei dieser Impulssequenz entsteht also zum Zeitpunkt dtl nach dem dritten Impuls ein reines Fett-bzw. ein reines Wasserbild und das gleiche Bild entsteht im zeitlichen Abstand dt3-dtl nach dem l80° Impuls, wobei dt3 der Abstand zwischen dem dritten Impuls und dem l80°-Impuls ist. Im zeitlichen Abstand dt3 + dtl nach dem l80° Impuls entsteht dagegen ein Bild mit der anderen Komponente (Wasser bzw. Fett).

Die Anordnung zur Durchführung des Verfahrens ist gekennzeichnet durch Mittel zur Erzeugung eines homogenen statischen Magnetfeldes, Mittel zur Erzeugung eines dazu senkrechten hochfrequenten Magnetfeldes Mittel zur Erzeugung von magnetischen Gradientenfeldern und Mittel zur Erzeugung eines ersten, eines zweiten und eines dritten Hochfrequenzimpulses, wobei der zweite und der dritte Hochfrequenzimpuls identisch sind und der zeitliche Abstand zwischen diesen Impulsen einem ungeradzahligen Vielfachen der Hälfte des Kehrwertes der Differenz der Larmorfrequenzen von an Wasser und an Fett gebundenen Wasserstoffprotonen entspricht.

Die Erfindung wird nachstehend anhand der Zeichnung näher erläutert. Es zeigen:

Fig. I ein Kernspinuntersuchungsgerät, bei dem die Erfindung anwendbar ist,

Fig. 2a ein Blockschaltbild eines solchen Gerätes

Fig. 2b eine Modifikation von Fig. 2a,

Fig. 3 den zeitlichen Verlauf verschiedener Signale bei einer erfindungsgemäßen Sequenz, und

Fig. 4 den zeitlichen Verlauf der Signale bei einer Modifikation dieser Sequenz.

Das in Fig. I schematisch dargestellte Kernspintomographiegerät enthält eine aus vier Spulen I bestehende Anordnung zur Erzeugung eines homogenen stationären Magnetfeldes von beispielsweise 2T. Die zur z-Achse konzentrisch angeordneten Spulen können auf einer Kugeloberfläche 2 angeordnet sein. Im Innern dieser Spulen befindet sich der zu untersuchende Patient 20.

Zur Erzeugung eines in z-Richtung verlaufenden und sich in dieser Richtung linear ändernden Magnetfeldes Gz sind vier Spulen 3 vorzugsweise auf der gleichen Kugeloberfläche angeordnet. Weiterhin sind vier Spulen 7 vorgesehen, die ein ebenfalls in z-Richtung verlaufendes Magnetfeld Gx erzeugen, dessen Gradient jedoch in x-Richtung verläuft. Ein in z-Richtung verlaufendes Magnetfeld Gy mit einem Gradienten in y-Richtung wird von vier Spulen 5 erzeugt, die mit den Spulen 7 identisch sein können, die jedoch diesen gegenüber um 90° räumlich versetzt angeordnet sind. Von diesen vier Spulen 5 sind in Fig. I nur zwei dargestellt.

Da jede der drei Spulenanordnungen 3, 5 und 7 zur Erzeugung der magnetischen Gradientenfelder Gz, Gy und Gx symmetrisch zur Kugeloberfläche 2 angeordnet ist, ist die Feldstärke im Zentrum der Kugel, das gleichzeitig den Koordinatenursprung eines kartesischen x-, y-, z-Koordinatensystems bildet, nur durch das stationäre homogene Magnetfeld der Spulenanordnung I bestimmt.

Weiterhin ist eine Hochfrequenzspule II symmetrisch zur Ebene z = 0 des Koordinatensystems angeordnet, die so ausgebildet ist, daß damit ein im wesentlichen homogenes in x-Richtung, d.h. senkrecht zur Richtung des stationären homogenen Magnetfeldes, verlaufendes hochfrequentes Magnetfeld erzeugt wird. Der Hochfrequenzspule wird während jedes Hochfrequenzimpulses ein hochfrequenter modulierter Strom von einem Hochfrequenzgenerator zugeführt.

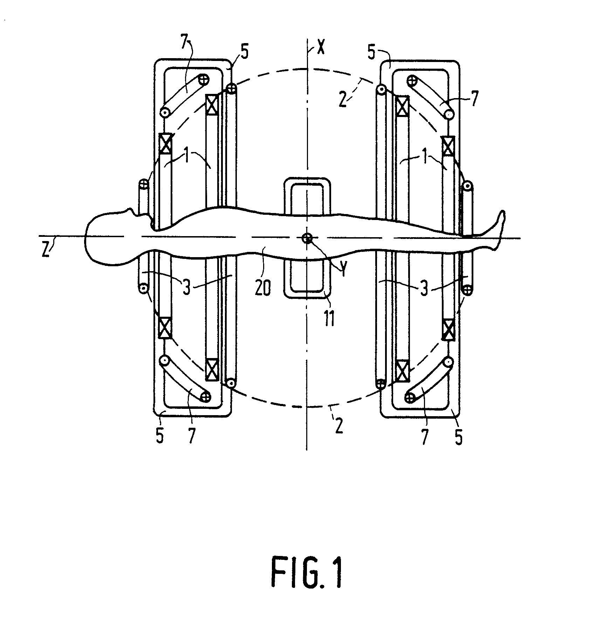

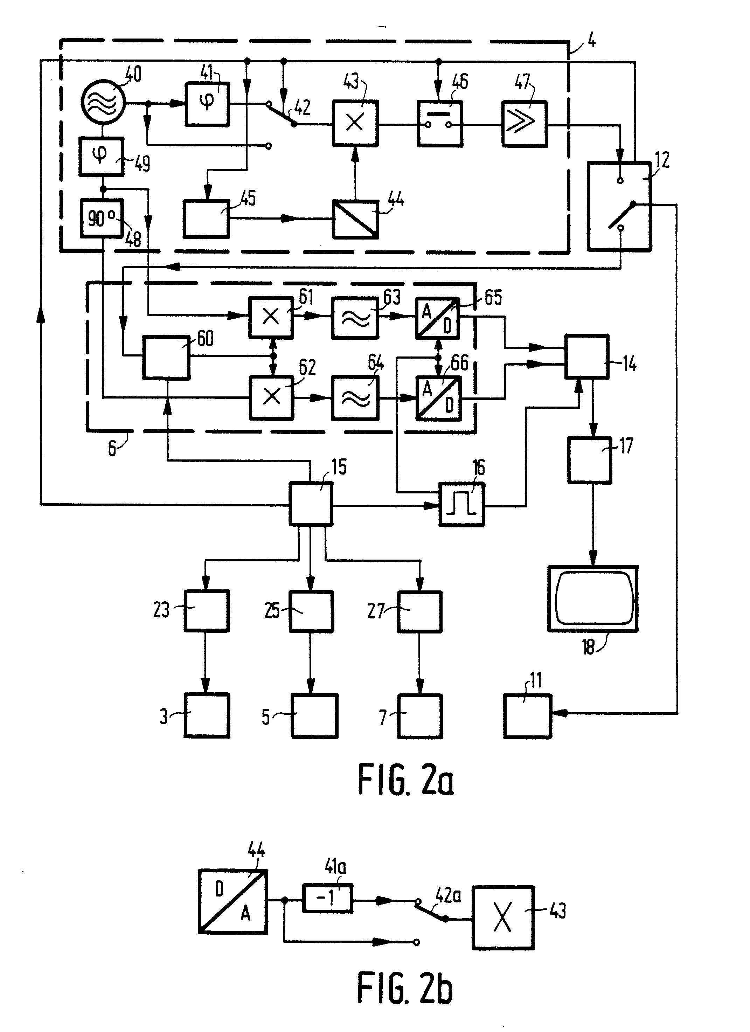

Fig. 2a zeigt ein vereinfachtes Blockschaltbild eines Kernspintomographen. Die Hochfrequenzspule II ist über eine Umschalteinrichtung I2 einerseits an einen Hochfrequenzgenerator 4 und andererseits an einen Hochfrequenzempfänger 6 angeschlossen.

Der Hochfrequenzempfänger 4 enthält einen Hochfrequenzgenerator 40, der Schwingungen mit einer Frequenz gleich der Larmorfequenz der an Wasser gebundenen Wasserstoffprotonen bei der von den Spulen I erzeugten Feldstärke aufweist; bei einer Feldstärke von 2 T beträgt diese Frequenz rund 85 MHz. Der Ausgang des Oszillators ist über einen Umschalter 42 mit einem Eingang einer Mischstufe 43 verbunden. In der einen Schaltstellung des Umschalters 42 erfolgt diese Verbindung direkt, während in der anderen, in der Zeichnung dargestellten Schaltstellung das Oszillatorsignal dem Eingang der Mischstufe über ein einstellbares Phasendrehglied 4I zugeführt wird. Der Mischstufe 43 wird ein zweites Eingangssignal von einem Digital-Analog-Wandler 44 zugeführt, dessen Eingang mit einem digitalen Speicher 45 verbunden ist. Aus dem Speicher 45 wird - gesteuert durch eine Steuereinrichtung I5, die auch den Umschalter 42 steuert - eine Folge von ein Hüllkurvensignal darstellenden Abtastwerten ausgelesen.

Die Mischstufe I7 verarbeitet die ihr zugeführten Eingangssignale so, daß an ihren Ausgang die mit dem Hüllkurvensignal modulierte Trägerschwingung erscheint. Das Hüllkurvensignal ist dabei so gewählt, daß sich ein vorzugsweise amplitudenmoduliertes Signal ergibt, dessen Bandbreite wesentlich größer ist als der Abstand der Larmorfrequenzen von Wasserstoffprotonen, die an Fett einerseits und an Wasser andererseits gebunden sind. Das Ausgangssignal der Mischstufe 43 wird über einen von der Steuereinrichtung I5 gesteuerten Schalter 46 einem Hochfrequenz-Leistungsverstärker 47 zugeführt, dessen Ausgang mit der Umschalteinrichtung I2 verbunden ist. Diese wird ebenfalls durch die Steuereinrichtung I5 gesteuert.

Der Empfänger 6 enthält einen Hochfrequenzverstärker 60, der mit der Umschalteinrichtung I2 verbunden ist und dem die in der Hochfrequenzspule II induzierten Kernspin-Resonanzsignale zu-

geführt werden, wenn die Umschalteinrichtung I2 entsprechend gesteuert ist. Der Verstärker 60 besitzt einen von der Steuereinrichtung I5 gesteuerten Stummschalteingang, über den der Verstärker 60 gesperrt werden kann, so daß die Verstärkung praktisch Null ist. Der Ausgang des Verstärkers 60 ist mit den ersten Eingängen zweier multiplikativer Mischstufen 6I und 62 verbunden, die jeweils ein dem Produkt ihrer Eingangssignale entsprechendes Ausgangssignal liefern. Dem zweiten Eingang der Mischstufen 6I und 62 wird ein Signal mit der Frequenz des Oszillators 40 zugeführt, wobei zwischen den Signalen an den beiden Eingängen eine Phasenverschiebung von 90° besteht. Diese Phasenverschiebung wird mit Hilfe eines 90°-Phasendrehgliedes 48 erzeugt, dessen Ausgang mit dem Eingang der Mischstufe 62 und dessen Eingang mit dem Eingang der Mischstufe 6I verbunden ist und das über ein einstellbares Phasendrehglied 49 mit dem Oszillator 40 verbunden ist.

Die Ausgangssignale der Mischstufen 6I und 62 werden über Tiefpässe 63 und 64, die die Oszillatorfrequenz sowie alle darüberliegenden Frequenzen unterdrücken und nur niederfrequente Anteile durchlassen, je einem Analog-Digital-Wandler 65 bzw. 66 zugeführt. Diese setzen die analogen Signale der einen Quadratur-Demodulator bildenden Schaltung 6I...64 in digitale Datenworte um, die einem Speicher I4 zugeführt werden. Die Analog-Digital-Wandler 65 und 66 sowie der Speicher I4 erhalten ihre Taktimpulse von einem Taktimpulsgenerator I6, der über eine Steuerleitung von der Steuereinrichtung I5 blockiert bzw. freigegeben werden kann, so daß nur in einem durch die Steuereinrichtung I5 definierten Meßintervall die von der Hochfrequenzspule II gelieferten, in den Niederfrequenzbereich transponierten Signale in eine Folge digitaler Datenworte umgesetzt und in dem Speicher I4 gespeichert werden können.

Ein Rechner I7 ermittelt anhand der Werte im Speicher I4 die räumliche Verteilung der Kernmagnetisierung im Untersuchungsbereich und gibt die ermittelte Verteilung an einer geeigneten Wiedergabeeinheit, z.B. einem Monitor I8, aus. Die drei Spulenanordnungen 3, 5 und 7 werden von den Stromgeneratoren 23, 25 und 27 jeweils mit einem Strom versorgt, dessen zeitlicher Verlauf durch die Steuereinheit I5 steuerbar ist.

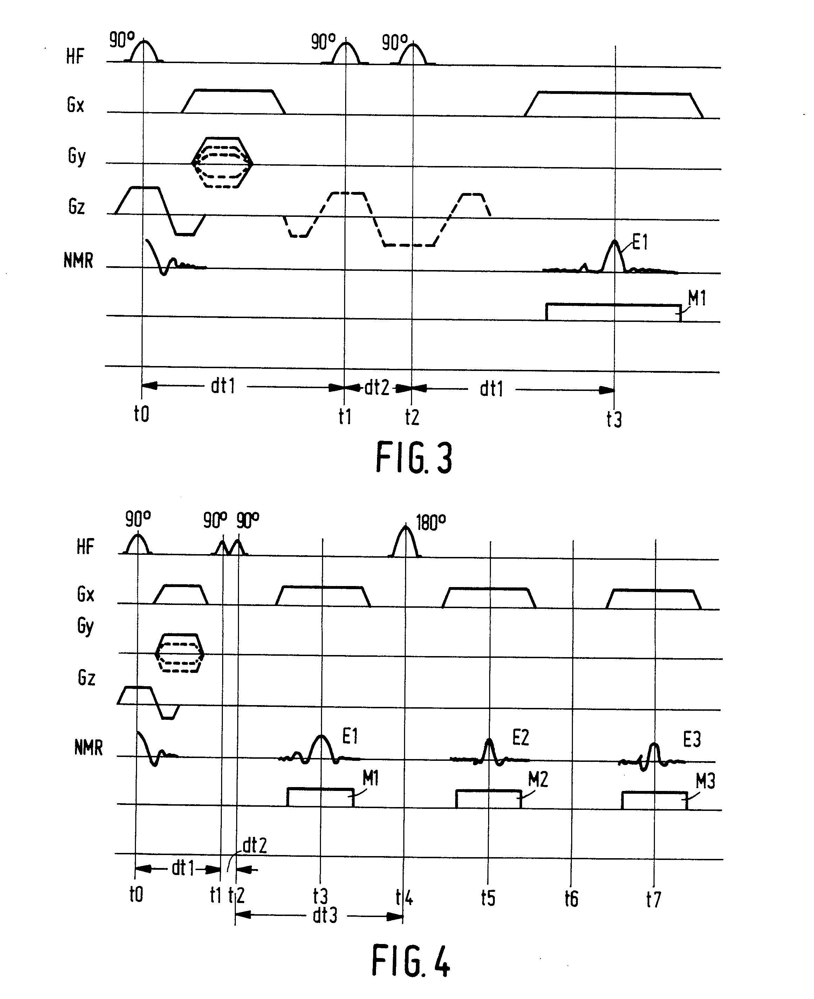

In Fig. 3 ist der zeitliche Verlauf verschiedener Signale in dem Kernspinuntersuchungsgerät dargestellt. Die erste Zeile zeigt die Sequenz der Hochfrequenzimpulse, während die letzte Zeile die Zeitachse darstellt. Die Sequenz besteht aus drei Hochfrequenzimpulsen, von denen jeder einen Flipwinkel von 90° aufweist. Dem ersten 90° Hochfrequenzimpuls zur Zeit t = t0 folgt im zeitlichen Abstand dtI ein zweiter Hochfrequenzimpuls zur Zeit t = tI. Der Wert dtI entspricht dem zeitlichen Abstand des I80° Impulses von dem vorangehenden 90° Impuls bei einer Spin-Echo-Sequenz. Zur Zeit t2 wird ein dritter 90° Hochfrequenzimpuls erzeugt; dessen zeitlicher Abstand vom zweiten Hochfrequenzimpuls entspricht dt2. Bei jedem Hochfrequenzimpuls ist der Schalter 45 geschlossen und die Umschalteinheit I2 in der in Fig. 2a nicht dargestellten Schaltstellung.

In der vierten Zeile ist der zeitliche Verlauf des magnetischen Gradientenfeldes Gz dargestellt. Es ist während des ersten Hochfrequenzimpulses wirksam und bewirkt, daß nur in einer zur Ebene z = 0 symmetrischen Schicht eine Kernspinresonanz angeregt werden kann. Der zeitliche Verlauf des von dem Stromgenerator 23 gelieferten Stromes für die Gradientenspulen 3 wird von der Steuereinheit I5 dabei so gesteuert, daß das zeitliche Integral über das magnetische Gradientenfeld im Intervall t0 bis tI Null wird.

Nach dem ersten Hochfrequenzimpuls wird der Stromgenerator 25 so gesteuert, daß während eines festen Zeitraums innerhalb des Intervalls t0-tI die Spulenanordnung 5 ein magnetisches Gradientenfeld Gy erzeugt, dessen Amplitude von Sequenz zu Sequenz variiert, wie gestrichelt angedeutet ist. Nach dem Abschalten dieses Gradientenfeldes hat daher die Kernmagnetisierung in den einzelnen Punkten der angeregten Schicht eine Phasenlage, die linear von der y-Koordinate abhängt. Dieses magnetische Gradientenfeld dient der Phasenkodierung und gestattet die Rekonstruktion der räumlichen Verteilung der Kermagnetisierung anhand der Kernspin-Resonanzsignale.

In der fünften Zeile ist der zeitliche Verlauf der Kernspinresonanzsignale dargestellt. Neben einem unmittelbar nach dem ersten Hochfrequenzimpuls auftretenden sogenannten FID-Signal tritt ein weiteres Kernspinresonanzsignal EI auf. Dieses Signal setzt sich aus einem stimulierten Echoanteil und einem Spin-Echo-Anteil zusammen.

Der stimulierte Echoanteil hat sein Maximum zur Zeit t3 in einem Abstand von dem dritten Hochfrequenzimpuls, der dem zeitlichen Abstand dtI des zweiten vom ersten Hochfrequenzimpuls entspricht, also zur Zeit t2 + dtI. Der stimulierte Echoanteil entspricht dabei der Summe von Wassersignal und Fettsignal. Als Wassersignal wird dabei der als stimuliertes Echo auftretende Anteil des Echosignals bezeichnet, der sich ergeben würde, wenn in dem durch den Patienten 20 symbolisierten Untersuchsbereich kein Fett enthalten wäre; analog bezeichnet "Fettsignal" das sich bei Fehlen von Wasser im Untersuchungsbereich ergebende stimulierte Echosignal.

Außer dem stimulierten Echoanteil enthält das zur Zeit t3 auftretende Echosignal noch zwei Spin-Echo-Anteile. Der eine Spin-Echo-Anteil hat sein Maximum zur Zeit t3-dt2, während der andere sein Maximum zur Zeit t3 + dt2 hat. Die beiden Maxima liegen also beiderseits des Maximums des stimulierten Echoanteils und haben von diesem jeweils den zeitlichen Abstand dt2. Beide Anteile setzen sich ebenfalls aus einem Fett-und einem Wassersignal zusammen. Das Wassersignal hat jedoch die gleiche Phasenlage wie das Wassersignal im stimulierten Echoanteil, weil die Frequenz der Trägerschwingung gleich der Larmorfrequenz der in Wasser gebundenen Wasserstoffprotonen ist. Hingegen hat das Fettsignal in den verschiedenen Echokomponenten eine Phasenlage, die von dem zeitlichen Abstand zwischen den Maxima der verschiedenen Anteile abhängt sowie von der Differenz der Larmorfrequenzen für Fett und Wasser. Wenn für die Zeit dt2 die Beziehung

dt2 = 0,5n/df,

wobei n eine ungerade Zahl ist und df der Betrag der Differenz der Larmorfrequenzen von an Wasser gebundenen Wasserstoffprotonen einerseits und an Fett gebundenen Wasserstoffprotonen andererseits, dann beträgt die Phasenverschiebung der Fettsignale in den beiden Spin-Echo-Anteilen gerade + I80° bzw. -I80°, so daß sich die Fettsignale kompensieren und das zur Zeit t3 auftretende zusammengesetzte Echosignal ein reines Wassersignal ist.

Zur Erfassung des reinen Wassersignals wird daher, wie in der sechsten Zeile angedeutet, das in der Hochfrequenzspule II -oder einer gesonderten Empfangsspule -induzierte zusammengesetzte Echosignal nach Demodulation während eines Meßintervalls MI in eine Folge von digitalen Abtastwerten umgesetzt, mit deren Hilfe -nach dem weitere Sequenzen mit geänderten Gradientenfeldern verabreicht und die dann zu den entsprechenden Zeitpunkten auftretenden Echosignale abgetastet worden sind -ein Bild der Wasserverteilung rekonstruiert wird. Die zeitliche Lage dieses Meßintervalls und der zeitliche Verlauf des mit Hilfe des Stromgenerators 27 in der Spule 7 erzeugten magnetischen Gradientenfeldes Gx sind so gewählt, daß das zeitliche Integral über das magnetische Gradientenfeld im Anschluß an den dritten Hochfrequenzimpuls während des Meßintervalls die gleche Größe erreicht, wie das zeitliche Integral über das gleiche schon zwischen den beiden Hochfrequenzimpulsen wirksame Gradientenfeld im Intervall von t0 bis tI. Vorzugsweise ist die Wahl dabe so getroffen, daß das Meßintervall MI symmetrisch zum Zeitpunkt t3 liegt und die erwähnten Integrale zum selben Zeitpunkt einander gleich werden; in diesem Fall ergibt sich das optimale Signal-Rauschverhältnis.

Damit die beschriebene Erzeugung eines reinen Wasserbildes (bw. eines reinen Fettbildes) nicht gestört wird, ist es wesentlich, daß, falls im Zeitraum zwischen tI und t2 ein magnetisches Gradientenfeld anliegt, dieses -wie in Fig. 3 gestichelt angedeutet -so gestaltet ist, daß das zeitliche Integral über das Magnetfeld im Zeitraum von tI bis t2 Null ist. Der gestrichelte Verlauf des magnetischen Gradientenfeldes Gz ist dann erforderlich, wenn man nach der dargestellten Sequenz zunächst aus einer benachbarten Schicht mit einer entsprechenden Sequenz Echosignale gewinnen will -(sogenannte Multi-Slice-Technik). Das gestrichelt angedeutete Feld verhindert nämlich, daß die benachbarte Schicht -oder andere Schichten -durch die vorhergehende Sequenz zur Kernspinresonanz angeregt wird.

Aus dem vorstehenden wird deutlich, daß sich nach dem bisher beschriebenen Verfahren ein reines Wasserbild ergibt, weil die Frequenz der vom Oszillator I9 erzeugten Schwingung gleich der Larmorfrequenz der an Wasser gebundenen Wasserstoffprotonen ist. Es leuchtet ein, daß sich ein reines Fettbild ergibt, wenn die Oszillatorfrequenz der Larmorfrequenz der an Fett gebundenen Wasserstoffprotonen entspricht. Um wahlweise entweder ein reines Fettbild oder ein reines Wasserbild anfertigen zu können, müßte also der Oszillator von der einen Frequenz auf die andere Frequenz umschaltbar sein, so daß die Sequenzen jeweils mit der einen oder der anderen Trägerfrequenz durchgeführt würden.

Man kann aber auch die Frequenz des Oszillators unverändert lassen, wenn man die Phasenlage, die in einem mit der Larmorfrequenz um die z-Achse rotierenden Koordinatensystem die mitrotierende Komponente des hochfrequenten Magnetfeldes aufweist, um I80° dreht.

Eine Möglichkeit, um die Phasenumkehr des dritten Impulses zu erreichen, besteht darin, daß zwischen dem zweiten und dem dritten Impuls der Eingang der Mischstufe 43 von dem Ausgang des Oszillators 40 auf den Ausgang des Phasendrehgliedes 4I umgeschaltet wird, der ein Signal führt, das gegenüber dem Signal am Ausgang des Oszillators um I80° gedreht ist. -Eine andere Möglichkeit, um die erläuterte I80°-Umkehr vor dem dritten Impuls zu erreichen, besteht darin, daß die Phasenlage des Hüllkurvensignals invertiert wird. Gemäß Fig. 2b kann dies beispielsweise dadurch erfolgen, daß ein Umschalter 42a (der ebenfalls von der Steuereinrichtung I5 gesteuert werden müßte) zwischen dem zweiten und dem dritten Hochfrequenzimpuls aus seiner gezeichneten Stellung, in der er den Ausgang einer dem Digital-Analog-Wandler 44 nachgeschalteten Phasenumkehrstufe 4Ia mit dem Eingang der Mischstufe 43 verbindet, in die nicht gezeichnete Stellung umgeschaltet wird, in der er den Ausgang des Digital-Analog-Wandlers 44 direkt mit dem Eingang der Mischstufe 43 verbindet.

Es ist jedoch nicht unbedingt erforderlich, daß die Frequenz der Oszillatorschwingung mit der Larmorfrequenz entweder von Wasser oder von Fett übereinstimmt. Die Frequenz kann auch einen anderen Wert haben, jedoch muß dann die Phasenlage des dritten Hochfrequenzimpulses gegenüber derjenigen des zweiten Hochfrequenzimpulses umgeschaltet werden, und zwar um den Phasenwinkel, den eine Schwingung mit der Differenzfrequenz zwischen der Larmorfrequenz von Fett bzw. Wasser einerseits und der Oszillatorfrequenz andererseits in der Zeit dt2 zwischen dem zweiten und dem dritten Hochfrequenzimpuls zurücklegt. Liegt die Frequenz der Oszillatorschwingungen beispielsweise genau in der Mitte der Larmofrequenzen für Fett und Wasser, dann muß zwischen dem zweiten und dem dritten Hochfrequenzimpuls die Phasenlage um -90° für Fett und um +90° für Wasser umgeschaltet werden. In diesem Fall müßte also die Phasenverschiebung durch das Phasendrehglied 4I bzw. 42 auf +90° oder -90° eingestellt sein.

Fig. 4 zeigt eine Erweiterung der erfindungsgemäßen Pulssequenz, die bis zum Zeitpunkt t2 mit der zuvor erläuterten Sequenz identisch ist. Die Erweiterung besteht darin, daß im zeitlichen Abstand dt3 vom dritten Hochfrequenzimpuls, d.h. zur Zeit t4 ein weiterer Hochfrequenzimpuls erzeugt wird, allerdings mit einem Flipwinkel von I80°. Wenn die Trägerfrequenz bei diesen Impulsen der Larmorfrequenz von an Wasser gebundenen Wasserstoffprotonen entspricht, ergibt sich zur Zeit t3 ein erstes Echosignal EI, das ausschließlich von der Wasserverteilung bestimmt wird, wie schon in Verbindung mit Fig. 3 erläutert. Zur Zeit t5, d.h. im Abstand dt3-dtI von dem I80°-Impuls, ergibt sich ein weiteres Echosignal E2, das ebenfalls ein reines Wassersignal ist. Zur Zeit t7 im zeitlichen Abstand von dt3 + dtI nach dem I80°-Impuls, tritt ein Echosignal E3 auf, das ausschließlich von der Fettverteilung bestimmt ist. Die drei Echosignale EI, E2 und E3 werden in Anwesenheit eines Meßgradienten Gx (vgl. Zeile 2 von Fig. 4) während der Meßintervalle MI, M2 und M3 abgetastet (vgl. Zeile 6). Es können damit mit einer einzigen Sequenz also Wassersignale (EI, E2) und ein Fettsignal (E3) gewonnen werden.

Wie der zeitliche Verlauf des Meßgradientenfeldes Gx und die zeitliche Lage des Meßintervalls gewählt sein müssen, damit das Echosignal EI ausgewertet werden kann, ist bereits in Verbindung mit Fig. I erläutert worden.

Damit das zweite Echosignal E2 empfangen werden kann, müssen die Gradientenfelder mit Ausnahme des der Phasenkodierung dienenden Gradientenfeldes Gy bestimmte Integralbedingungen erfüllen. Da das Integral über das magnetische Gradientenfeld Gz im Intervall von t0 bis tI Null ist

und dieses Gradientenfeld in dem darauffolgenden Zeitraum der Sequenz nicht mehr geschaltet wird, gilt für das Gradientenfeld Gx, daß die Summe der Integrale über dieses Gradientenfeld im Zeitraum von t0 bis tI und im Zeitraum nach dem I80°-Impuls (t4) während des Meßintervalls M2 für die Erfassung von E2 den gleichen Wert erreichen muß, wie das zeitliche Integral über dieses Gradientenfeld im Zeitraum zwischen dem dritten Hochfrequenzimpuls (t2) und dem I80°-Impuls (t4). Ein optimales Signal-Rauschverhältnis ergibt sich wiederum dann, wenn diese Bedingung zum Zeitpunkt t = t5 erfüllt ist und das Meßintervall M2 (Zeile 6) symmetrisch zu t5 liegt.

Damit schließlich das dritte Echosignal E3 empfangen werden kann, muß das zeitliche Integral über das Gradientenfeld Gx im Zeitraum nach dem I80°-Impuls während eines Meßintervalls M3 die gleiche Größe erreichen, wie das Integral über dieses Gradientenfeld zwischen dem ersten (90°-) Hochfrequenzimpuls und dem I80°-Hochfrequenzimpuls, d.h. im Zeitraum tI bis t4. Optimale Verhältnisse ergeben sich wiederum, wenn diese Bedingung zur Zeit t = t7 erfüllt ist und das Meßintervall symmetrisch zu diesem Zeitpunkt liegt.

Wenn abweichend von Fig. 3 bzw. von Fig. 4 die zeitlichen Integrale über das Gradientenfeld in den Zeitabschnitten zwischen dem ersten und dem zweiten sowie zwischen dem dritten Hochfrequenzimpuls und dem I80°-Impuls nicht gleich Null sein, so müssen diese Integrale für einen optimalen Empfang der Signale EI, E2, E3 folgende Bedingungen genügen: Für einen optimalen Empfang von EI muß das zeitliche Integral über Gz vom ersten Hochfrequenzimpuls bis zum zweiten Hochfrequenzimpuls gleich dem Integral vom dritten Hochfrequenzimpuls bis zum Beginn des Meßintervalls MI sein. Für einen optimalen Empfang von E2 muß das zeitliche Integral über Gz vom dritten Hochfrequenzimpuls bis zum I80°-Impuls gleich der Summe aus den Integralen vom ersten Hochfrequenzimpuls bis zum zweiten und vom I80°-Impuls bis zum Beginn des Meßintervalls M2 sein. Für einen optimalen Empfang von E3 muß das zeitliche Integral über Gz vom ersten Hochfrequenzimpuls bis zum I80°-Impuls gleich dem Integral vom I80°-Impuls bis zum Beginn des Meßintervalls M3 sein.

Wie bereits erwähnt, müssen bei dem anhand von Fig. 3 erläuterten Verfahren der zweite und der dritte Hochfrequenzimpuls in bezug auf den Flipwinkel identisch sein. Der Flipwinkel muß aber nicht 90° betragen, obwohl sich dabei das beste Signal-Rausch-Verhältnis ergibt. Bei der erweiterten, in Fig. 4 dargestellten Sequenz muß der Flipwinkel des zweiten und des dritten Hochfrequenzimpulses jedoch 90° betragen.

Das in Fig. 4 dargestellte Verfahren kann noch dadurch erweitert werden, daß im zeitlichen Abstand von 2dt3 oder 4dt3, 6dt3 usw. nach dem 180°-Impuls ein oder mehrere weitere 180°-Impulse zugesetzt werden, wobei weitere Echosignale entstehen, die ausschließlich von der Wasserverteilung oder ausschließlich von der Fettverteilung beeinflußt sind. Im zeitlichen Abstand dt3 von dem ersten 180°-Impuls, d.h. zur Zeit t = t6, darf jedoch kein 180°-Impuls hinzugefügt werden, weil dann das dritte Echosignal E3 ebenso wie die beiden ersten El und E2 ausschließlich von der Wasserverteilung bestimmt wäre.

Vorstehend wurde ein Verfahren zur Erzeugung eines Bildes einer zur z-Achse senkrechten Schicht beschrieben. Durch Vertauschen der Gradientenansteuerungen lassen sich jedoch mit dem gleichen Verfahren auch Schichtaufnahmen in anderen Richtungen in bekannter Weise erzeugen.

Das anhand der Fig. 3 und 4 erläuterte Verfahren ist ein sogenanntes zweidimensionales Fourier-Transformationsverfahren. Die Erfindung ist jedoch auch bei einem dreidimensionalen Fourier-Transformationsverfahren anwendbar, bei dem in den einzelnen Sequenzen zwecks Phasenkodierung zusätzlich zum Feld Gy auch das magnetische Gradientenfeld Gz von Sequenz zu Sequenz variiert wird. -Weiterhin kann die Erfindung auch bei sogenannten Projektions-Rekonstruktionsverfahren angewandt werden. Dieses Verfahren unterscheidet sich dadurch von dem Verfahren nach Fig. 3, daß nicht die Größe des Gradienten von Sequenz zu Sequenz variiert wird, sondern die Richtung des Gradienten, während der Betrag des Gradienten konstant bleibt. Hierbei erfolgt keine Phasenkodierung, sondern eine Frequenzkodierung und die der Frequenzkodierung dienenden Gradientenfelder müssen die zuvor schon erläuterten Integralbedingungen erfüllen.

## Ansprüche

l. Kernspintomographieverfahren, bei dem in einer Vielzahl von Sequenzen in Anwesenheit eines stationären homogenen Magnetfeldes ein dazu senkrecht verlaufendes Hochfrequenz-Magnetfeld sowie magnetische Gradientenfelder in einem Untersuchungsbereich wirksam sind, wobei in jeder Sequenz zunächst ein erster Hochfrequenzimpuls erzeugt wird und anschließend ein zweiter und ein dritter Hochfrequenzimpuls, die miteinander identisch sind, wobei das zeitliche Integral über die Gradientenfelder zwischen dem zweiten und dem dritten Hochfrequenzimpuls Null ist und wobei ein in einem Meßintervall nach dem dritten Hochfrequenzimpuls auftretendes Echosignal zur Erzeugung eines Bildes des Untersuchungsbereiches herangezogen wird, dadurch gekennzeichnet , daß zur getrennten Erzeugung von Fett-bzw. Wasserbildern der zeitliche Abstand (dt2) zwischen dem zweiten und dem dritten Hochfrequenzimpuls die Hälfte des Kehrwertes der Differenz der Larmorfrequenzen von in Wasser und in Fett gebundenen Wasserstoffprotonen ist oder ein ungeradzahliges Vielfaches davon.

2. Verfahren nach Anspruch I, dadurch gekennzeichnet, daß die zeitliche Lage des Meßintervalls (MI) und der zeitliche Verlauf der Gradientenfelder derart gewählt ist, daß das zeitliche Integral über die Gradientenfelder (Gx, Gz) - mit Ausnahme etwaiger der Phasenkodierung dienender Gradientenfelder (Gy) -zwischen dem ersten und dem zweiten Hochfrequenzimpuls gleich dem zeitlichen Integral über diese Gradientenfelder zwischen dem dritten Hochfrequenzimpuls und dem Meßintervall (MI) ist, und daß der zeitliche Abstand (dtl) des Meßintervalls vom dritten Hochfrequenzimpuls gleich dem zeitlichen Abstand des zweiten Hochfrequenzimpulses vom ersten Hochfrequenzimpuls ist.

3. Verfahren nach Anspruch I oder 2, dadurch gekennzeichnet, daß der zweite und der dritte Impuls einen Flipwinkel von je 90° aufweisen.

4. Verfahren nach Anspruch 3, dadurch gekennzeichnet, daß in jeder Sequenz im Anschluß an den dritten Hochfrequenzimpuls noch ein 180°-Impuls erzeugt wird, und daß die zeitliche Lage des Meßintervalls und der zeitliche Verlauf der Gradientenfelder derart ist, daß das zeitliche Integral über die Gradientenfelder (Gx, Gz) -mit Ausnahme etwaiger für die Phasenkodierung bestimmter Gradientenfelder (Gy) -im Zeitraum nach dem Hochfrequenzimpuls den Wert des zeitlichen Integrals über dieses Feld zwischen dem ersten Hochfrequenzimpuls und dem 180°-Hochfrequenzimpuls während des Meßintervalls (M3) erreicht.

5. Verfahren nach Anspruch 4, dadurch gekennzeichnet, daß die zeitliche Lage des Meßintervalls (M3) und der zeitliche Verlauf der Gradientenfelder (Gx, Gz) so gewählt ist, daß der zeitliche Abstand zwischen dem Meßintervall - (M3) und dem 180°-Hochfrequenzimpuls gleich der Summe der Abstände zwischen dem ersten und dem zweiten (dtl) sowie zwischen dem dritten und dem 180°-Hochfrequenzimpuls dt3) ist.

6. Verfahren nach einem der vorhergehenden Ansprüche, dadurch gekennzeichnet, daß der zeitliche Mittelwert der Frequenz des Hochfrequenzimpulses der Larmorfrequenz von an Wasser gebundenen oder von an Fett gebundenen Wasserstoffprotonen entspricht.

7. Verfahren nach einem der Ansprüche I bis 6, dadurch gekennzeichnet, daß die Phase des dritten Hochfrequenzimpulses gegenüber der Phase des zweiten Hochfrequenzimpulses um einen Winkel verschoben wird, den eine Schwingung mit der Differenzfrequenz zwischen der Oszillatorfrequenz und der Larmorfrequenz von Fett oder Wasser in der Zeit zwischen dem zweiten und dem dritten Hochfrequenzimpuls zurücklegt.

8. Anordnung zur Durchführung des Verfahrens nach Anspruch I,
gekennzeichnet durch Mittel (I) zur Erzeugung eines homogenen statischen Magnetfeldes, Mittel zur Erzeugung eines dazu senkrechten hochfrequenten Magnetfeldes (II), Mittel (3, 5, 7) zur Erzeugung von magnetischen Gradientenfeldern (Gx, Gy, Gz) und Mittel (I2, I5) zur Erzeugung eines ersten, eines zweiten und eines dritten Hochfrequenzimpulses, wobei der zweite und der dritte Hochfrequenzimpuls identisch sind und der zeitliche Abstand (dt2) zwischen diesen Impulsen einem ungeradzahligen Vielfachen der Hälfte des Kehrwertes der Differenz der Larmorfrequenzen von an Wasser und an Fett gebundenen Wasserstoffprotonen entspricht.

9. Anordnung nach Anspruch 8,
dadurch gekennzeichnet, daß die Mittel zur Erzeugung der Hochfrequenzimpulse einen Oszillator -(I9) zur Erzeugung von Trägerschwingungen mit der Larmorfrequenz, einen Generator zur Erzeugung von Hüllkurvensignalen (2I, 22) und eine Mischschaltung (I7) enthalten, die ein dem Produkt der Trägerschwingung mit dem Hüllkurvensignal entsprechendes Ausgangssignal liefert.

I0. Anordnung nach Anspruch 9,
dadurch gekennzeichnet, daß Mittel (4I; 4Ia) zum Umschalten der Phasenlage des Hüllkurvensignals oder der Trägerschwingung zwischen dem zweiten und dem dritten Hochfrequenzimpuls vorgesehen sind.

II. Anordnung nach Anspruch 8,
dadurch gekennzeichnet, daß die Oszillatorfrequenz von der Larmorfrequenz der in Fett gebundenen Wasserstoffprotonen auf die Larmorfrequenz der in Wasser gebundenen Wasserstoffprotonen umschaltbar ist.

I2. Anordnung nach einem der Ansprüche 8 bis I0 zur Durchführung des Verfahrens nach Anspruch 4,
dadurch gekennzeichnet, daß die Mittel (I2, I5) zur Erzeugung der Hochfrequenzimpulse so gestaltet sind, daß nach dem dritten Hochfrequenzimpuls ein I80° Impuls erzeugt wird.

# FIG. 1

FIG. 2a

FIG. 2b

FIG. 3

FIG. 4

3-III-PHD 85-182